**Europäisches Patentamt**

**European Patent Office**

**Office européen des brevets**

(11) Veröffentlichungsnummer: **0 148 379**
**A1**

(12) **EUROPÄISCHE PATENTANMELDUNG**

(21) Anmeldenummer: **84114051.0**

(22) Anmeldetag: **20.11.84**

(51) Int. Cl.⁴: **H 05 K 3/46, B 32 B 31/12**

(30) Priorität: **02.12.83 DE 3343745**

(43) Veröffentlichungstag der Anmeldung: **17.07.85**
**Patentblatt 85/29**

(84) Benannte Vertragsstaaten: **AT BE CH DE FR GB IT LI LU NL SE**

(71) Anmelder: **Siemens Aktiengesellschaft, Berlin und München Wittelsbacherplatz 2, D-8000 München 2 (DE)**

(72) Erfinder: **von Tomkewitsch, Sybille, Ascheringer Weg 4, D-8134 Pöcking (DE)**
Erfinder: **Schmidt, Hans-Friedrich, Dr., Graf-Trattenbach-Weg 3, D-8191 Eurasburg (DE)**

(54) **Mehrlagenschaltungen aus Thermoplast-Kupfer-Verbund.**

(57) Zur Herstellung von Mehrlagenschaltungen, bei denen die Innenlagen aus dem in der FR-PS 2 094 162 beschriebenen flexiblen Basismaterial bestehen und als Prepreg der Thermoplast dieses Basismaterials eingesetzt wird, werden die Leiterplatten nahe der Schmelztemperatur des Thermoplasten getempert, anschließend mehrere Leiterplatten unter Verwendung des gleichen, nicht getemperten Thermoplasten sandwichartig aufgebaut und nahe der Schmelztemperatur des ungetemperten Thermoplasten verpreßt. Bei der Herstellung eines Direktverbundes – Mehrlagenschaltung/Flexible Leiterplatte – werden ein oder mehrere Abschnitte der flexiblen Leiterplatte bei der Herstellung der Mehrlagenschaltung entweder als Prepreg oder als Innenlage direkt mitverpreßt.

Siemens Aktiengesellschaft        Unser Zeichen
Berlin und München               VPA 83 P 1922

Mehrlagenschaltungen aus Thermoplast-Kupfer-Verbund.

Die Erfindung betrifft ein Verfahren zur Herstellung von Mehrlagenschaltungen, bei denen abwechselnd Isolierschichten aus Thermoplast mit elektrisch leitenden Schichten zu einem Mehrlagenverbund zusammengebracht sind. Unter Mehrlagenschaltungen sollen Multilayer, Mikropack und Mehrlagenleitungen verstanden werden.

Bei der Herstellung von Mehrlagenschaltungen werden sogenannte Innenlagen (meist Epoxidharz-Basismaterial, bei dem beide Flächen Leiterführungen besitzen) mit sogenannten Prepregs im Mehrlagenaufbau verpreßt. Prepregs sind mit härtbaren Kunstharzen vorimprägnierte Bahnen, meist Glasfasermatten oder Glasseidengewebe, die durch Warmpressen zu Formteilen oder Halbzeug verarbeitet werden. Als Bindemittel dienen vor allem Reaktionsharzmassen auf der Grundlage von EP-UP-Harzen oder Polydiallylphthalat.

Wie in der FR-PS 2 094 162 beschrieben ist, wird bei der Herstellung des obengenannten Basismaterials die Thermoplastfolie bei ihrer Schmelztemperatur mit den Kupferfolien verpreßt. Hierbei handelt es sich aber nur um Basismaterial und nicht um Mehrlagenschaltungen. Um Mehrlagenschaltungen herzustellen ist es erforderlich, mehrere Leiterplatten durch Zwischenfügen von Isolierschichten zu verbinden. Dies könnte zum Beispiel durch Verwendung von

    Isolierfolien mit Klebschichten,
    EP-Prepregs oder

Wed 1 Plr/26.7.1984

Thermoplasten mit niedrigerer Schmelztemperatur
als die des Trägermaterials der Innenlage geschehen.

Diese Isolierschichten stellen aber Schwachstellen im
Verbund dar. Darunter fällt zum Beispiel geringere
Temperaturbeständigkeit der Klebstoffe und geringere Lagerfähigkeit bei Verwendung von EP-Prepregs.

Will man auf den Einsatz eines Klebers, der - wie ausgeführt - als Schwachstelle wirkt, verzichten, muß die Mehrlagenplatte nach dem gleichen Verfahren hergestellt werden wie das Basismaterial in der DE-OS 32 05 591. In diesem Fall wird aber nicht nur die Prepregfolie, sondern
auch die Trägerfolie der Innenlage erweichen. Die Folge
davon ist ein "Wegschwimmen" der Leiterbahnen und somit
Unbrauchbarkeit der Mehrlagenschaltung.

Der Erfindung liegt die Aufgabe zugrunde, das eingangs
genannte Verfahren zu realisieren um die genannten Nachteile zu beseitigen.

Untersuchungen haben gezeigt, daß einige Thermoplaste,
wie zum Beispiel PPS (Polyphenylensulfid) oder das in der
FR-PS 2 094 162 genannte PEEK (Polyetheretherketon) die
Eigenschaft besitzen, durch Tempern bei Temperaturen nahe
ihrer Schmelztemperatur bei der nächsten Erwärmung anschließend bei wesentlich höheren Temperaturen zu schmelzen. So wird bei PEEK zum Beispiel durch eine Temperung
von 150 h bei 310°C eine Schmelzpunktverschiebung um
27°C, das heißt von 342° auf 369°C erreicht. Die Erfindung macht sich diese Erkenntnis zunutze.

Die Lösung der Erfindung besteht darin, daß die Leiterplatten nahe der Schmelztemperatur des Thermoplasten getempert werden, anschließend mehrere Leiterplatten unter
Verwendung des gleichen, nicht getemperten Thermoplasten sandwichartig aufgebaut und nahe der Schmelztemperatur
des ungetemperten Thermoplasten verpreßt werden. Der wesentliche Vorteil der Erfindung liegt darin begründet,
daß ein optimaler Verbund erreicht und auf den Einsatz
einer Kleberfolie vollkommen verzichtet werden kann.
Durch die Verschiebung der Schmelztemperatur nach höheren
Werten schmilzt die Trägerfolie nicht auf und die Leitungsbahnen bleiben stehen.

Unter Nutzung dieser Eigenschaften ist es auch möglich,
die in der FR-PS 2 094 162 beschriebene flexible Leiterplatte direkt mit dem Multilayer zu verpressen und so ein
stabiles Verbundsystem - Multilayer/Flexible Leiterplatte
- herzustellen.

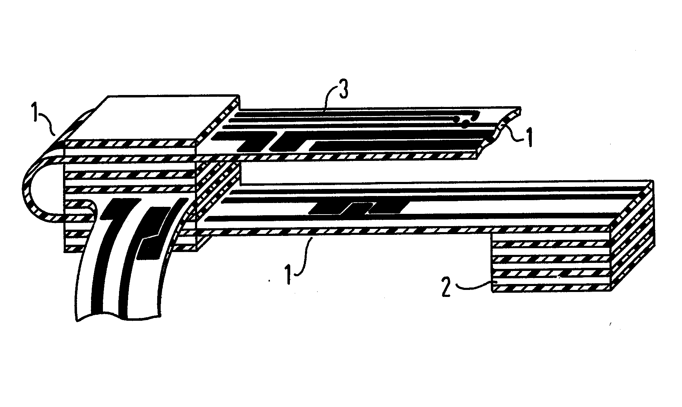

Die Erfindung wird anhand der Figur erläutert, die in
perspektivischer Darstellung den Aufbau einer Multilayer-
Schaltung in Direktverbund mit flexiblen Monolayern auf
Basis PEEK zeigt.

Der Verbund besteht aus mehreren Monolayern 1, der sandwichartig mit PEEK 2 als Prepreg aufgebaut ist. Die Monolayer bestehen zum Beispiel aus PEEK mit einem Schmelzpunkt von zum Beispiel 370°, auf denen Leiterbahnen 3 einseitig oder zweiseitig aufgebracht sind. Das Prepreg 2
besteht zum Beispiel aus PEEK mit einem Schmelzpunkt von
zum Beispiel 342°C.

Soll der mit dem Multilayer zu verpressende Anteil der
flexiblen Leiterplatte nicht nur als Prepreg, sondern als
Innenlage eingesetzt werden, so muß die flexible
Schaltung ebenfalls vor dem Verpressen zum Multilayerverbund entsprechend getempert werden.

Bei der Verwendung von PEEK ergeben sich zum Beispiel
noch folgende Vorteile:

0148379

1. Unempfindlichkeit gegenüber Feuchteeinwirkung.

2. Unbegrenzte Lagerfähigkeit der Vorprodukte.

3. Bessere Wärmebeständigkeit.

4. PEEK kann im Gegensatz zu EP-Harz extrudiert werden.

5. Strahlenbeständigkeit.


2 Patentansprüche

1 Figur

Patentanspruch

1. Verfahren zur Herstellung von Mehrlagenschaltungen, bei denen abwechselnd Isolierschichten aus Thermoplast mit elektrisch leitenden Schichten zu einem Mehrlagenverbund zusammengebracht sind, d a d u r c h   g e - k e n n z e i c h n e t ,   daß die Leiterplatten nahe der Schmelztemperatur des Thermoplasten getempert werden, anschließend mehrere Leiterplatten unter Verwendung des gleichen, nicht getemperten Thermoplasten sandwichartig aufgebaut und nahe der Schmelztemperatur des ungetemperten Thermoplasten verpreßt werden.

2. Verfahren zur Herstellung eines Direktverbundes - Mehrlagenschaltung/Flexible Leiterplatte -,   d a d u r c h   g e k e n n z e i c h n e t ,   daß ein oder mehrere Abschnitte der flexiblen Leiterplatte bei der Herstellung der Mehrlagenschaltung entweder als Prepreg oder als Innenlage direkt mitverpreßt werden.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | FR-A-2 094 162 (E.I. DU PONT DE NEMOURS & CO.) <br><br> * Seiten 1-4; Ansprüche * <br><br> --- | 1 | H 05 K 3/46 <br> B 32 B 31/12 |
| A | EP-A-0 087 051 (SIEMENS AG.) <br><br> * Insgesamt * | 1 | |
| D | & DE-A-3 205 591 <br><br> --- | | |
| A | FR-A-2 455 616 (KOLLMORGEN TECHNOLOGIES CORP.) <br><br> * Seiten 8-10; Seite 15, Zeile 4 - Seite 16, Zeile 22; Ansprüche 1-4 * <br><br> --- | 1,2 | |
| | | | **RECHERCHIERTE SACHGEBIETE (Int. Cl.4)** |
| A | US-A-3 244 795 (P.R. LATIMER) <br><br> * Insgesamt * <br><br> --- | 1,2 | H 05 K <br> B 32 B |
| A | GB-A- 841 217 (STANDARD TELE-PHONES AND CABLES Ltd.) <br><br> * Seiten 1-4; Figuren * <br><br> ----- | 1 | |

Der vorliegende Recherchenbericht wurde für alle Patentansprüche erstellt.

| Recherchenort | Abschlußdatum der Recherche | Prüfer |
|---|---|---|
| DEN HAAG | 14-02-1985 | VISENTIN A. |